# EUROPÄISCHE PATENTSCHRIFT

(11) **EP 1 022 354 B1**
(45) Veröffentlichungstag und Bekanntmachung des Hinweises auf die Patenterteilung: **11.02.2009**
(21) Anmeldenummer: 99124999.6
(22) Anmeldetag: 15.12.1999
(51) Int. Cl.: C23C 16/30, C23C 16/40, B05D 7/24, G02B 1/10

(54) **Verfahren zum Beschichten von Substraten aus Kunststoff**
Process for coating plastic substrates
Procédé de revêtement de substrats en matière plastique

(30) Priorität: 19.01.1999 DE 19901834
(43) Veröffentlichungstag der Anmeldung: 26.07.2000
(60) Teilanmeldung: 07022469.6
(73) Patentinhaber: Oerlikon Deutschland Holding GmbH, 80331 München (DE)
(72) Erfinder: Grünwald, Heinrich, Dr., 61194 Niddatal (DE); Schulte, Thomas, 63450 Hanau (DE); Nauenburg, Klaus, Dr., 63456 Hanau (DE); Dicken, Wilfried, 63607 Wächtersbach (DE); Beckmann, Rudolf, Dr., 63454 Hanau (DE)
(74) Vertreter: Heine-Kempkens, Claus

(56) Entgegenhaltungen:
- DE-A- 19 522 865
- US-A- 5 051 308
- US-A- 5 494 712
- US-A- 5 508 368
- PATENT ABSTRACTS OF JAPAN vol. 014, no. 090 (C-0691), 20. Februar 1990 (1990-02-20) & JP 01 301723 A (CANON INC), 5. Dezember 1989 (1989-12-05)
- VALLON S ET AL: "Improvement of the adhesion of silica layers to polypropylene induced by nitrogen plasma treatment" THIN SOLID FILMS, ELSEVIER-SEQUOIA S.A. LAUSANNE, CH, Bd. 290-291, 15. Dezember 1996 (1996-12-15), Seiten 68-73, XP004173292 ISSN: 0040-6090

## Beschreibung

Die Erfindung betrifft ein Verfahren zum beschichten von Substraten aus Kunststoff mit einem transparenten, kratz- und abriebunempfindlichen und gegen Witterungseinflüsse beständigen Schichtpaket mit einem in einer Vakuumkammer in einigem Abstand vom Substrat brennenden Plasma.

Es ist bekannt, Kunststoffgegenstände durch Aufbringen einer lackartigen Schicht, die im Falle transparenter Kunststoffe ihrerseits transparent sein muß, zu schützen. Im letzteren Fall werden mit Erfolg Acrylat-, Polyurethan-, Siloxan-, Ormocer- oder Nanocerbeschichtungen verwendet, die in unterschiedlichem Maße sowohl Kratz-, Abriebals auch UV-Schutz bieten. Allen diesen Beschichtungen ist gemeinsam, daß sie mit den üblichen Lackauftragstechniken aufzutragen sind. Hieraus leitet sich eine Reihe von Nachteilen ab, die allgemein in Lösemittelemissionen sowie Problemen mit der Bedeckungsgleichmäßigkeit, der Aushärtung oder mit Verstaubung bestehen. Die Lösung dieser Probleme sowie das Beschichtungsmaterial selbst sind mit erheblichen Kosten verbunden.

Eine Alternative besteht im Aufbringen von anorganischen Schutzschichten, beispielsweise aus Siliziumoxid, mit Hilfe von Gasphasenabscheidung im Vakuum. So wird in der WO 97/23661 ein Hochratenverdampfungsverfahren von einem Oxidbildner vorgeschlagen, wobei zur Verbesserung der Schichteigenschaften Sauerstoff oder Stickstoff und zusätzlich gasförmige Monomer in die Verdampfungszone geleitet werden und dieses Gemisch eine hochdichte Plasmazone in der Nähe des zu beschichtenden Substrats durchläuft.

Ein weiteres, sehr effektives Verfahren besteht im Aufbringen einer optisch transparenten Schutzschicht durch plasmachemische Gasphasenabscheidung (engl. "Plasma Chemical Vapor Deposition", PCVD). Hierbei werden Siliziumverbindungen, meist in Form von Silanen (DE 26 50 048 und EP 0 252 870), Silazanen oder Siloxanen, häufig Hexamethyldisiloxan (HMDSO), meist mit Zusatz von Sauerstoff in einem Niedertemperaturplasma zu einer Schicht umgesetzt "polymerisiert". Weiter wird in der US 5,298,587 eine mit PCVD hergestellte Schicht der allgemeinen Zusammensetzung SiO_{1,8-2,4}C_{0,3-1,0}H_{0,7-4,0} als Abriebschutz für verschiedene, insbesondere aus diversen Polycarbonaten bestehenden Kunststoffteile vorgeschlagen. Als eine Weiterentwicklung wird in DD 238 630 vorgeschlagen, einer siliziumorganischen Verbindung Stickstoff und zusätzlich ein Trägergas, beispielsweise Argon zuzusetzen. In der EP 0 317 134 wird ein beschichteter Gegenstand mit einer transparenten, abriebbeständigen Schicht beschrieben, die durch Plasma-CVD eines ungesättigten Kohlenwasserstoffs zusammen mit einem Silan oder Fluorsilan und einer Sauerstoffquelle hergestellt wird, wobei die Zusammensetzung der Schicht im wesentlichen durchweg gleichförmig ist.

Durch geeignete Prozeßführung kann die Zusammensetzung dieser Schichten in einem weiten Bereich variiert werden, wobei sich Schichten, die reich an Kohlenwasserstoffanteilen sind, durch eine bestimmte Verformbarkeit, solche die arm an Kohlenwasserstoffanteilen und damit siliziumoxidartig sind, durch Härte und Abriebbeständigkeit auszeichnen. Dies kann dazu verwendet werden, auf Kunststoffgegenständen mit relativ geringer Härte Schichten aufzutragen, deren Härte zu ihrer Oberfläche hin ansteigt (DE 34 13 019, US 4,927,704, US 5,051,308, EP 0 267 679, WO 97/13802). Hierdurch kann der unterschiedliche thermische Ausdehnungskoeffizient von Kunststoffmaterial und Beschichtung ausgeglichen werden, was sich in verbesserter Haftbeständigkeit der Schicht bemerkbar macht.

In der DE 42 38 279 wird vorgeschlagen, Kunststoffgegenstände mit einer für sichtbares Licht transparenten, haftfesten und kratzfesten Schicht zu überziehen, welche auch eine gute Barrierewirkung gegen Wasser, Chemikalien und UV-Strahlung aufweist. Hierzu wird innerhalb von mindestens drei Tiefenbereichen einer mindestens aus Silizium, Sauerstoff und Kohlenstoff bestehenden Beschichtung eine unterschiedliche chemische Zusammensetzung eingestellt, wobei der Gehalt an Silizium und Sauerstoff allgemein mit der Schichtdicke zu- und der Gehalt an Kohlenstoff allgemein mit der Schichtdicke abnimmt. Eine ausreichende UV-Schutzwirkung ist erfahrungsgemäß jedoch nicht erzielbar.

Es bleibt jedoch das Problem, daß mit PCVD hergestellte SiOxCyHz- oder SiNxCyHz-Schichten als solche ungeachtet ihrer genauen Stöchiometrie UV-Strahlung transmittieren. Dies ist besonders nachteilig, wenn die Kunststoffgegenstände aus besonders UV-empfindlichen Kunststoffen bestehen, wie z. B. Polycarbonat (PC). Denn die Oberfläche dieser Kunststoffe kann trotz beigemischten UV-Absorbern derart geschädigt werden, daß sich eine hierauf aufgebrachte PCVD-Schutzschicht ablöst. Es fehlt deshalb nicht an Versuchen, transparente PCVD-Schutzschichten für UV-Strahlung undurchdringlich zu machen. Hierzu wird nach der US 5,156,882 eine PCVD-Kratzschutzschicht mit einer zusätzlichen, UV-absorbierenden PVCD-Schicht aus ZnO, TiO₂, CeO₂ oder V₂O₅ kombiniert. Nachteilig ist jedoch, daß eine solche zusätzliche Schicht mit einem höheren Brechungsindex als der Kunststoff und als die Kratzschutzschicht durch ihre Farberscheinung unangenehm auffallen kann, insbesondere dann, wenn ihre Schichtdicke über dem einzelnen Kunststoffgegenstand ungleichmäßig ist. Dieser Effekt verliert sich mit Schichtdicken größer als etwa 1 µm wieder, jedoch ist der Auftrag solcher Dicken bei den relativ niedrigen Aufwachsraten dieser Schichten nicht wirtschaftlich.

In der EP 92 400 581 und der EP 0 502 790 werden PCVD-Mehrschichtsysteme beschrieben, die als UV-Interferenzfilter wirken. Auch hier sind Unterschiede in der Schichtdicke optisch auffällig und damit kritisch.

In der US 5,270,854 wird eine optische Filterbeschichtung bestehend aus einem Farbstoff, der in eine verdünnende, anorganische Schicht (vorzugsweise aus aufgedampftem SiO₂) eingelagert ist, vorgeschlagen, wobei als Substratmaterial PC verwendet wird, das mit einer Barriereschicht aus plasmapolymerisiertem HMDSO und einer Schutzschicht aus einem Silikonpolymer vorbeschichtet wird.

Nach der JP 6025448, der JP 1301723 und der DE 195 22 865 wird ein organischer UV-Absorber während eines PCVD-Prozesses zum Auftrag einer Kratzschutzschicht verdampft und in die Schicht eingebaut. Da gerade die wirtschaftlichsten PCVD-Prozesse auf einem hohen Fragmentationsgrad der Ausgangssubstanzen beruhen, ist die Gefahr groß, daß bei hohen Auftragsgeschwindigkeiten der UV-Absorber zu stark fragmentiert und damit unwirksam wird.

Umgekehrt wurde auch versucht, aus Azeton, 2-Butanon oder Benzol UV-absorbierende Substanzen während des Auftrags einer PCVD-Kratzschutzschicht im Plasma herzustellen. UV-Bewitterungstests zeigten.jedoch keine Verbesserung der UV-Stabilität.

Schließlich wird in der EP 0 285 870 eine Lösung angegeben, bei der PC-Teile zunächst mit einer Zwischenschicht, bestehend aus einem Organosilikonharz, das eine UV-schützende Verbindung enthält, vorbeschichtet und anschließend mit einer abriebschützenden Deckschicht, die mittels Plasma-CVD hergestellt wird, überzogen werden.

Die Oberfläche technischer Kunststoffe ist meist empfindlich gegenüber mechanischer Beanspruchung wie Abrieb oder Verkratzen. Bei Außenanwendungen wird die Einsatzdauer häufig durch mangelnde UV-Beständigkeit begrenzt, da das Material vergilbt und/oder trübe wird. Dies ist insbesondere bei Kunststoffgegenständen von Nachteil, deren Funktion an die Transparenz des Materials geknüpft ist, z. B. bei Helmvisieren, Abdeckscheiben von Kfz-Scheinwerfern, Sichtscheiben von Pkws oder Kunststoffscheiben an Gebäuden.

Der vorliegenden Erfindung liegt nun die Aufgabe zugrunde, eine transparente Schutzbeschichtung für transparente Kunststoffe wie Polycarbonat (PC), Polymethylmethacrylat (PMMA) oder CR 39 zu schaffen, die nicht nur verbesserte Kratz- und Abriebfestigkeit, sondern auch verbesserte Beständigkeit gegen Lichteinstrahlung, Temperatur- und Feuchtigkeitseinflüsse, wie sie beispielsweise für Außenbewitterung charakteristisch sind, aufweist und dabei die Nachteile der Naßauftragstechnik vermeidet.

Diese Aufgabe wird erfindungsgemäß durch das Verfahren gemäß Anspruch 1 gelöst.

Weitere Einzelheiten und Merkmale sind in den Patentansprüchen näher erläutert und beschrieben.

Vorzugsweise werden mit Hilfe eines mit Mikrowellen oder einer Hochfrequenz angeregten Remote-Plasmas, das nicht in unmittelbarer Nachbarschaft der zu beschichtenden Kunststoffteile, sondern in einigem Abstand von den zu beschichtenden Teilen erzeugt wird und somit indirekt, d. h. durch aus dem Bereich der hell leuchtenden Zone des Plasma herausfliegende, langlebige, energiereiche Teilchen auf das Reaktionsgasgemisch einwirkt, nacheinander folgende Prozesse durchgeführt:
Eine Vorbehandlung der zu beschichtenden Teile und der Prozeßkammer unter Verwendung eines Plasmas. Die Vorbehandlung besteht in einem oder einer Kombination der im folgenden aufgeführten Verfahrensschritte, die entsprechend dem Zustand der zu beschichtenden Kunststoffoberflächen gewählt werden.

Zur Entfernung organischer Verunreinigungen von der Oberfläche der Kunststoffteile werden oxidierende Gase wie Sauerstoff, Distickstoffoxid oder Stickstoff eingesetzt.

Bei ungenügend trockenen Kunststoffteilen oder anderweitigem Zutritt von Wasser in die Prozeßkammer werden Gase und oder Dämpfe eingesetzt, die unter Plasmaeinwirkung leicht mit Wasser reagieren, bevorzugt sauerstofffreie oder -arme flüchtige Aluminium, Zinn-, Zink-, Titan-, Bor-, Siliziumverbindungen wie deren Hydride, Alkyle, bedingt auch Alkoxide, z. B. Triethylaluminium, Tetramethylzinn, Diethylzinn, Triethylborat, Silan, Tetramethylsilan, Dimethyldiethoxysilan oder Trimethylethoxisilan. Bevorzugt werden jedoch Gase oder Dämpfe von Verbindungen, die unter Plasmaeinwirkung Wasserstoff- oder Alkylradikale bilden, verwendet, wie Wasserstoff oder kurzkettige Aldehyde, Ketone, Alkohole oder Carbonsäuren. Beispiele hierfür sind Formaldehyd, Azetaldehyd, Essigsäure, Azeton, Ethanol oder Methanol. Besonders bevorzugt werden Wasserstoff oder Methanol.

Anschließend an eine oder mehrere der o. g. Behandlungen eine Vernetzung der Kunststoffoberflächenschicht mit einem direkt oder indirekt einwirkenden Plasma eines oder mehrerer inerter Gase wie Argon oder Helium vorgenommen. Auch Stickstoff kann hierzu verwendet werden. In diesem Fall ist zu beachten, daß auch eine oxidierende Wirkung eintritt.

Die Gasmischung wird dazu derart eingestellt, daß die Oberfläche der Kunststoffgegenstände möglichst wenig mit UV-Strahlung von Wellenlängen, die das jeweilige Kunststoffmaterial schädigen, aus dem Plasma belastet wird. Im Falle von zu beschichtenden Teilen aus Polycarbonat (PC) werden Wellenlängen zwischen 200 nm und 340 nm vermieden. Hierzu werden geeignete Gase oder Gasmischungen zum Betrieb des Plasmas verwendet. Das weitgehende Fehlen schädlicher Wellenlängen kann mit einem geeigneten Spektrometer für die optische Emission des Plasmas beurteilt werden. Alternativ kann in einer Remote-Plasmaanordnung durch Einbau optisch dichter Blenden zwischen Plasma und die zu behandelnden Teile eine UV-Strahlenbelastung der Teile weitgehend vermieden werden. Dies gilt auch für die Herstellung der nächstfolgenden, einer diffusionshemmenden Sperrschicht.

Zusätzlich zu einer Plasmavorbehandlung kann es vorteilhaft sein, die zu beschichtenden Teile auf eine Temperatur zwischen 320 K und 390 K, je nach dem zu beschichtenden Werkstoff, zu erwärmen, beispielsweise mittels einer IR-Strahlungsheizung.

Beim Aufbringen der sehr dünnen (< 100 nm) diffusionshemmenden Sperrschicht auf den plasmavorbehandelten Kunststoffteilen ist der Prozeß so zu führen, daß die Schicht gleichzeitig als Barriere gegen Sauerstoff, Wasser und Fragmente organischer Moleküle wirkt. Hierdurch wird verhindert, daß unter UV-Einfluß von Bewitterung gebildete Fragmente der Kunststoffmoleküle abdiffundieren und die Rekombination gebildeter Radikale gefördert. Durch Absperren der Oberfläche gegen Sauerstoff und Wasser wird die Photooxidation gebildeter Radikale unterbunden. Im Ergebnis wird der Abbau des Kunststoffs verzogert. Die Sperrschicht neigt um so weniger zur Ablösung, je dünner sie ist. Es kommt also darauf an, eine möglichst effektive Sperrschicht mit einer bevorzugten Schichtdicke von < 50 nm aufzubringen. Die Sperrschicht kann beispielsweise aus einem Oxid wie Siliziumoxid, Aluminiumoxid, Magnesiumoxid oder einem Nitrid wie Siliziumnitrid, einem Mischoxid oder einem Oxinitrid bestehen.

Im Falle unzureichender Haftung der Sperrschicht auf den Teilen ist es vorteilhaft, die Sperrschicht im Anschluß an die nachfolgend beschriebene Unterschicht aufzubringen oder ganz auf sie zu verzichten, falls die Kratz- und Abriebschutzschicht genügend Barrierewirkung aufweist.

Anschließend erfolgt das Aufbringen mindestens einer haftungsvermittelnden und mechanische Spannungen ausgleichenden Unterschicht mit Hilfe eines Plasmas. Hierzu können eine oder mehrere schichtbildende Substanzen aus der Gasphase auf den relativ hierzu kalt gehaltenen Kunststoffteilen ohne Plasmaeinwirkung auskondensiert und anschließend mit Hilfe eines Plasmas in einer plasmainduzierten Polymerisation in eine feste Schicht umgewandelt werden. Als schichtbildende Substanzen kommen organische, bevorzugt metallorganische Substanzen mit konventionell polymerisierenden funktionellen Gruppen wie C-C-Doppelbindungen oder Oxiranringen zum Einsatz, beispielsweise Acrylate, Methacrylate, Epoxi- oder, bevorzugt, Vinyl- oder Allylverbindungen.

Alternativ können eine oder mehrere geeignete Verbindungen unter dauernder, direkter oder indirekter Einwirkung eines Plasmas zur Reaktion gebracht und als Schicht auf den Kunststoffteilen aufgebracht werden. Hierzu können grundsätzlich alle genügend flüchtigen organischen oder metallorganischen Verbindungen eingesetzt werden. Bevorzugt werden jedoch wenig ungesättigte oder gesättigte organische Verbindungen, die unter diesen Bedingungen Schichten mit relativ geringer Absorption sichtbaren Lichts bilden. Bevorzugt sind silizium-organische Verbindungen, aus denen sich noch leichter absorptionsarme Schichten herstellen lassen. Hier ist jedoch zu beachten, daß die Schichten nicht zu reich an Sauerstoff oder Stickstoff sein dürfen, da sie sonst ihre geforderte Eigenschaft, mechanische Spannungen zwischen der eigentlichen Schutzschicht und dem Kunststoffteil aufzufangen, verlieren. Die Unterschicht kann einen Härtegradienten aufweisen, so daß sie substratseitig weicher ist.

Anschließend erfolgt das Aufbringen mindestens einer kratz- und abriebschützenden Schutzschicht unter Einwirkung eines Plasmas auf mindestens eine siliziumorganische Verbindung, die gas- oder dampfförmig in die Prozeßkammer eingebracht wird. Zur Verbesserung der mechanischen Schichteigenschaften wird hierbei Sauerstoff oder eine sauerstoffhaltige, gas- oder dampfförmige Verbindung, z. B. Distickstoffoxid zugesetzt. Im Falle indirekter Plasmaeinwirkung wird der Zustrom von Sauerstoff oder der sauerstoffhaltigen Verbindung mit Vorteil aufgeteilt und sowohl als Anregungsgas (welches die Plasmazone durchquert und von ihm angeregt wird) als auch als Trägergas (das zusammen mit der siliziumorganischen Verbindung stromabwärts vom Plasma eingeleitet wird) eingesetzt. Im übrigen können als Anregungsgas und/oder Trägergas auch Argon, Stickstoff, Kohlendioxid einheitlich bzw. in unterschiedlichen Kombinationen eingesetzt werden. Durch Zusatz von < 20 % eines Edelgases, bevorzugt Helium oder Argon zum Plasma, im Falle indirekter Plasmaeinwirkung zum Anregungsgas, werden Abriebbeständigkeit und Barrierewirkung der Schicht heraufgesetzt. Es kann sinnvoll sein, mehrere solcher Schutzschichten mit jeweils unterschiedlichen Eigenschaften zu kombinieren, derart, daß die Härte von Schicht zu Schicht abwechselnd höher oder niedriger ist oder mit der aufgebrachten Gesamtschichtdicke zunimmt. Alternativ kann durch kontinuierliche Veränderung der Schichtherstellungsparameter innerhalb der kratz- und Abriebschutzschicht ein Eigenschafts- (z. B. Härte-)gradient erzielt werden.

Die Abriebbeständigkeit wird erfindungsgemäß gesteigert, indem auf die Schutzschicht eine weitere Schicht aufgebracht wird, die sich durch einen niedrigen Reibungskoeffizienten auszeichnet (Gleitschicht). Eine solche Schicht wird erfindungsgemäß ebenfalls mit Plasma-CVD oder Remoteplasma-CVD hergestellt. Hierzu werden als Ausgangssubstanzen reine Kohlenwasserstoffe, Fluorkohlenstoffe oder, bevorzugt siliziumorganische Verbindungen ohne gesonderten Zusatz von Sauerstoff verwendet.

Es ist wesentlich, daß in die Unterschicht mindestens eine UV-Strahlung absorbierende Substanz (= UV-Absorber) eingebaut wird. Als UV-Absorber können sowohl organische als auch überwiegend anorganische Substanzen eingesetzt werden.

Bei Einsatz organischer UV-Absorber wird folgendermaßen verfahren: Die UV-absorbierende Substanz wird thermisch im Vakuum unter weitgehender Abwesenheit eines Plasmas verdampft und in die aufwachsende Schicht eingeschlossen. Es stellte sich heraus, daß es vorteilhaft sein kann, gemeinsam mit dem UV-Absorber wenigstens eine weitere Verbindung mit ähnlichem Siedepunkt, bevorzugt eine siliziumorganische Verbindung, beispielsweise Diphenyldimethylsilan zu verdampfen. Generell erfolgt die Verdampfung des UV-Absorbers räumlich oder bevorzugt zeitlich getrennt vom Plasma, das die Herstellung der Schicht bewirkt. Dies wird ermöglicht, indern die Schicht mit Hilfe einer sogenannten "downstream"- oder "remote plasma"-Anordnung hergestellt wird und der Dampf des UV-Absorbers räumlich genügend weit getrennt vom Plasma möglichst nahe den Kunststoffteilen zugeführt wird. Alternativ werden der Verdampfungsvorgang und der die Unterschicht oder Schutzschicht bildende Plasmaprozeß gegentaktig gepulst, d. h. daß sich kurzzeitige Verdampfung des UV-Absorbers und Plasmaprozesse abwechseln, also im wesentlichen nicht gleichzeitig stattfinden. Hierbei kondensiert der Dampf des UV-Absorbers an den zu beschichtenden Teilen ohne Einwirkung des Plasmas und wird im nachfolgenden Plasmaprozeß in die dabei gebildete Unterschicht oder Schutzschicht eingebaut.

Als UV-Absorber können die hierfür bekannten Substanzen eingesetzt werden, soweit sie im Bereich des sichtbaren Lichts transparent und unzersetzt flüchtig sind, beispielsweise 2-Hydroxybenzophenone, Zimtsäureester oder Oxalanilide, bevorzugt 2-Hydroxyphenylbenzotriazole oder organische Nikkelkomplexe. Benzophenone und Zimtsäureester sind hierbei weniger bevorzugt, da die darin enthaltene Carbonylgruppe insbesondere unter direkter, aber auch indirekter Einwirkung eines Plasmas zur Elimination neigt und die UV-absorbierende Substanz hierdurch zersetzt wird. Der Prozeß muß so geführt werden, daß die UV-absorbierenden Substanzen möglichst nicht einer direkten Plasmaeinwirkung bzw. einer indirekten Plasmaeinwirkung nur mit einer geringen Dosis (Leistung x Zeit) ausgesetzt werden. Es wird bei Verwendung von UV-Absorbern, die unter Plasmaeinwirkung leicht zersetzt werden, bevorzugt, die UV-absorbierende(n) Substanz(en) pulsartig aufzudampfen und hierbei das Plasma kurzzeitig auszuschalten.

Die UV-Schutzwirkung von Schichten mit UV-Absorbern kann positiv beeinflußt werden, indem Alkohole, Ketone, Epoxide oder Wasser unter indirekter Plasmaeinwirkung zu Alkoxi- oder Hydroxiradikalen umgesetzt und in die aufwachsende Schicht eingebaut werden. Hierdurch können einerseits vom Plasma nachteiligerweise verursachte Elimiationen von Alkoxi- oder Hydroxigruppen von UV-Absorbern zumindest teilweise rückgängig gemacht und somit die UV-Extinktion erhöht werden. Zum anderen kann der zusätzliche Einbau von Alkoxi-, Hydroxi- oder Ketofunktionen in UV-absorbierende Verbindungen den Bereich der absorbierten UV-Wellenlängen erweitern, ohne daß störende Absorption im Bereich des sichtbaren Lichts auftreten.

Alternativ wird die UV-absorbierende Substanz mit Hilfe eines Plasmas synthetisiert. Hierzu werden geeignete Ausgangssubstanzen entweder direkt in einem Plasma oder indirekt, d. h. "downstream" oder "remote" von einem Plasma derart zur Reaktion gebracht, daß sich UV-absorbierende chemische Strukturen in der hierbei hergestellten Schicht ausbilden. Solche Strukturen zeichnen sich durch das Vorhandensein von π-Bindungssystemen mit vier oder mehr konjugierten Doppelbindungen aus. Diese können beispielsweise bestehen aus aromatischen Ringen, die mit weiteren Mehrfachbindungen beispielsweise in Form von Doppel- oder Dreifachbindungen unter Beteiligung von Kohlenstoff- und/oder Stickstoffatomen und dergleichen oder aber weiteren Aromaten konjugiert sind. Konjugation mit Carbonylgruppen ist ebenfalls möglich, aber weniger bevorzugt, da diese unter direkter oder indirekter Plasmaeinwirkung zur Elimination neigen. Es ist weiter zu beachten, daß zu stark ausgedehnte π-Bindungssysteme sichtbares Licht absorbieren. Der Prozeß muß so geführt werden, daß keine allzu ausgedehnten π-Bindungssysteme entstehen. Die hierbei auftretende Eigenfärbung der Beschichtung ist in der Regel unerwünscht. Geeignete Ausgangsverbindungen sind insbesondere o-Phenylendiamin zusammen mit o-Aminophenol oder o-Hydroxybenzonitril. Alternativ können beispielsweise 2-Aminophenol und Benzaldehyd, Methylcyanid und Phenol, Benzonitril und Phenol, Styrol und Sauerstoff oder Benzonitril und Brenzcatechin zu UV-absorbierenden Strukturen umgesetzt werden.

Der Einbau von UV-Absorbern kann gleichzeitig zu den Wachstumsreaktionen einer Unter- oder Schutzschicht erfolgen, beeinflußt diese jedoch derart, daß eine Abrieb- und Kratzschutzschicht durch den Einbau von organischen UV-absorbierenden Strukturen mechanisch weniger widerstandsfähig wird. Deshalb erfolgt der Einbau von organischen UV-Absorbern vorzugsweise in die Unterschicht.

Bei Einsatz anorganischer UV-Absorber wird folgendermaßen verfahren: Während des Aufbringens der Unterschicht und/oder der kratz- und abriebschützenden Schicht wird unter Einwirkung eines Sauerstoffplasmas eine oder mehrere dampfförmige Metallverbindungen in die Bestückungskammer eingelassen. Als Metallverbindungen werden solche eingesetzt, deren Metalle als solche oder zusammen mit Silizium UV-absorbierende Oxide, Oxinitride oder Nitride bilden und die einen genügend hohen Dampfdruck aufweisen. Beispiele sind Carbonyle, Metallocene, Alkyle, Nitrate, Acetylacetonate oder Alkoxiverbindungen der Metalle Cer, Zink, Titan, Vanadium oder bevorzugt des Blei, Nickel oder Zinn. Hierbei kann es erforderlich sein, dem Sauerstoffplasma Stickstoff zuzusetzen.

Bei einem erprobten Verfahren sind drei Beschichtungskammern mit jeweils einer großflächigen Mikrowellenplasmaquelle (gebildet aus einer Mehrzahl einzelner Mikrowellenantennen) mit einer Gesamtleistung von jeweils 8 kW (2,45 GHz) ausgerüstet. Die für die Plasmaprozesse benötigten Gase Sauerstoff, Argon und Hexamethyldisiloxan (HMDSO, als Dampf) werden über Massenflußdosiergeräte und mittels auf 45°C aufgeheizte Gaszuleitungen in die Beschichtungskammer eingeleitet. Das als UV-Absorber verwendete 2-(2H-Benzotriazol-2-yl)-4,6-di-tert.-pentylphenol (BPP) wird über getrennte, auf 180°C beheizte Gaszuleitungen aus einem auf 165°C geheizten Verdampfer in die Beschichtungskammer eingeleitet. Hierbei ist vorgesehen, daß die Gaszuleitung für Argon an der von den Kunststoffteilen abgewandten Seite der Mikrowellenplasmaquelle (stromaufwärts) an die Beschichtungskammer angeschlossen ist. Die Gaszuleitung für Sauerstoff mündet beidseitig, stromauf- und -abwärts der Mikrowellenplasmaquelle und die Gaszuleitungen für Hexamethyldisiloxan (HMDSO) und BPP münden nur auf der den Kunststoffteilen zugewandten Seite (stromabwärts) der Mikrowellenplasmaquelle in die Beschichtungskammer ein. Die Beschichtungskammer wird konstant mit einem Vakuumpumpstand mit einem Saugvermögen von 2000 m³/h evakuiert.

Als Substratmaterial werden spritzgegossene, weniger als 15 Tage und unter sauberen Bedingungen gelagerte Platten aus Polycarbonat (LS 2-111 von General Electric Plastics) verwendet.

Die Kunststoffteile werden auf einer rahmenförmige Halterung so befestigt, daß die zu beschichtende Seite während der Beschichtungsprozesse der jeweiligen Mikrowellenquelle zugewandt ist. Vor dem Einladen einer Halterung in eine Schleusenkammer werden die Kunststoffteile mit einer IR-Strahlungsheizung auf 363 K (70°C) erwärmt.

Die Halterung wird in die Schleusenkammer geladen. Daraufhin wird eine Beladetür verschlossen und die Schleusenkammer mit Hilfe eines Vakuumpumpstandes evakuiert. Während dessen wird die Halterung von einem Hebelmechanismus in eine Ausnehmung einer im Innern einer ebenfalls unter Vakuum stehenden Transportkammer angeordneten drehbaren Substrataufnahme übergeben. Nach Erreichen eines Drucks von 2 Pa werden vier innerhalb der Anlage angeordnete Schleusenventile, welche die Beschichtungskammern und die Schleusenkammer zusammen mit der jeweils gegenüberstehenden Ausnehmung der Substrataufnahme gegenüber einer Transportkammer abdichten, geöffnet und die Substrataufnahme um 90° gedreht. Hierdurch werden die zuletzt auf der Halterung eingeschleusten Kunststoffteile in die erste Beschichtungskammer transportiert, wobei die zu beschichtende Seite der Mikrowellenplasmaquelle gegenübersteht. Die Schleusenventile werden geschlossen und so die Schleusenkammer und die Beschichtungskammern wieder gegenüber der Transportkammer abgedichtet. Nun werden nacheinander folgende Remoteplasmaprozesse durchgeführt.

### Vorbehandlung:

### Reinigung:

400 cm³/min Sauerstoff (Einlaß stromaufwärts)
4 kW Mikrowellenleistung
Plasmadauer: 30 s

### Vernetzung:

100 cm³/min Argon (Einlaß stromaufwärts)
6 kW Mikrowellenleistung
Plasmadauer: 120 s

### Aufbringen einer Sperrschicht:

400 cm³/min Sauerstoff (Einlaß stromaufwärts)
500 cm³/min Sauerstoff (Einlaß stromabwärts)
100 cm³/min HMDSO
8 kW Mikrowellenleistung
Plasmadauer: 60 s

Anschließend wird die Halterung mit den Kunststoffteilen wie oben beschrieben in die folgende Beschichtungskammer weitertransportiert und folgende Prozeßfolge durchgeführt:

### Aufbringen der Unterschicht mit UV-Absorber:

400 cm³/min Sauerstoff (Einlaß stromaufwärts)
250 cm³/min HMDSO
6 kW Mikrowellenleistung
Plasmadauer: 25 s

400 cm³/min Sauerstoff (Einlaß stromaufwärts)
400 cm³/min Sauerstoff (Einlaß stromabwärts)
250 cm³/min HMDSO
6 kW Mikrowellenleistung
Plasmadauer: 25 s

400 cm³/min Sauerstoff (Einlaß stromaufwärts)
800 cm³/min Sauerstoff (Einlaß stromabwärts)
250 cm³/min HMDSO
6 kW Mikrowellenleistung
Plasmadauer: 25 s

400 cm³/min Sauerstoff (Einlaß stromaufwärts)
1200 cm³/min Sauerstoff (Einlaß stromabwärts)
250 cm³/min HMDSO
6 kW Mikrowellenleistung
Plasmadauer: 25 s

Während aller Prozeßschritte in dieser Beschichtungskammer wird ein konstanter Strom von BPP mit einem Partialdruck von 2 Pa eingelassen.

### Aufbringen der Kratzschutzschicht:

400 cm³/min Sauerstoff (Einlaß stromaufwärts)
1200 cm³/min Sauerstoff (Einlaß stromabwärts)
250 cm³/min HMDSO
8 kW Mikrowellenleistung
Plasmadauer: 120 s

Anschließend wird die Halterung mit den Kunststoffteilen wie oben beschrieben in die folgende Beschichtungskammer weitertransportiert und folgende Prozeßfolge durchgeführt:

### Aufbringen der Kratzschutzschicht:

400 cm³/min Sauerstoff (Einlaß stromaufwärts)
100 cm³/min Argon
1200 cm³/min Sauerstoff (Einlaß stromabwärts)
250 cm³/min HMDSO
8 kW Mikrowellenleistung
Plasmadauer: 200 s

### Aufbringen der Gleitschicht:

400 cm³/min Argon
250 cm³/min HMDSO
6 kW Mikrowellenleistung
Plasmadauer: 25 s

Anschließend wird die Halterung mit den Kunststoffteilen weiter in die Schleusenkammer transportiert und nach Belüften der Schleusenkammer wieder aus der Anlage entnommen.
Es versteht sich, daß die Anlage mit Vorteil so betrieben wird, daß jeweils eine Halterung in einer der Beschichtungskammern und der Schleusenkammer synchron bearbeitet wird.

## Patentansprüche

1. Verfahren zum Beschichten von Substraten aus Kunststoff mit einem transparenten, kratz- und abriebunempfindlichen und gegen Witterungseinflüsse beständigen Schichtpaket mit einem in einer Vakuumkammer brennenden Plasma, **dadurch gekennzeichnet, dass**
- in einem ersten Verfahrensschritt zum Zwecke der Substratreinigung ein oxydierendes Gas in die Prozesskammer eingelassen wird,
- in einem zweiten Verfahrensschritt zum Zwecke der Vernetzung ein inertes Gas in die Prozesskammer eingelassen wird,
gegebenenfalls in einem dritten Verfahrensschritt zum Aufbringen einer ersten Sperrschicht ein oxydierendes Gas und eine siliziumorganische Verbindung in die Prozesskammer eingelassen werden,
- in einem vierten Verfahrensschritt zum Aufbringen einer Unterschicht mit UV-Absorber ein oxydierendes Gas, eine siliziumorganische Verbindung und eine UV-absorbierende Verbindung eingelassen werden,
wobei die UV-absorbierende Verbindung sowohl eine organische als auch eine anorganische Substanz sein kann
und bei organischer Substanz diese thermisch im Vakuum unter weitgehender Abwesenheit des Plasmas verdampft und in die aufwachsende Schicht eingeschlossen wird
und bei anorganischer Substanz unter Einwirkung eines Sauerstoffplasmas eine oder mehrere dampfförmige Metallverbindungen eingelassen werden, deren Metalle als solche oder zusammen mit Silizium UV-absorbierende Oxiden, Oxinitriden oder Nitriden bilden,
wobei das Verhältnis von oxydierendem Gas zu der siliziumorganischen Verbindung während der Dauer des vierten Verfahrensschrittes von etwa Null zu Eins stufenweise und/oder mit Unterbrechungen erhöht wird und das Plasma kontinuierlich oder im Pulsbetrieb brennt,
- in einem fünften Verfahrensschritt zum Aufbringen einer Kratzschicht ein oxydierendes Gas und eine siliziumorganische Verbindung in die Prozesskammer eingelassen werden und
- in einem sechsten Verfahrensschritt zum Aufbringen einer Gleitschicht ein inertes Gas und ohne gesonderten Zusatz von Sauerstoff eine siliziumorganische oder Fluorkohlenstoffverbindung in die Prozesskammer eingelassen werden,
wobei die Gleitschicht sich durch einen niedrigeren Reibungskoeffizienten als die Kratzschicht auszeichnet.

## Claims

1. Method for coating substrates of plastics with a transparent layer package which is resistant to scratches, abrasion and weather influences, with a plasma burning in a vacuum chamber, **characterised in that**
- in a first process step, an oxidising gas is introduced into the process chamber for the purposes of substrate cleaning,
- in a second process step, an inert gas is introduced into the process chamber for the purposes of cross-linking,
- where applicable in a third process step, an oxidising gas and a silicon-organic compound are introduced into the process chamber for application of a first barrier layer,
- in a fourth process step, an oxidising gas, a silicon-organic compound and a UV-absorbent compound are introduced for application of a sub-layer with UV absorber,
wherein the UV-absorbent compound can be both an organic and an inorganic substance,
and in the case of an organic substance, this vaporises thermally in the vacuum largely in the absence of plasma and is included in the growing layer,
and in the case of an inorganic substance, under the effect of an oxygen plasma,
one or more vapour-like metal compounds are introduced, the metals of which as such or together with silicon form UV-absorbent oxides, oxinitrides or nitrides,
wherein over the duration of the fourth process step, the ratio of oxidising gas to silicon-organic compound is increased from around nil to one in steps and/or with interruptions and the plasma burns continuously or in pulse mode,
- in a fifth process step, an oxidising gas and a silicon-organic compound are introduced into the process chamber for application of a scratch layer, and
- in a sixth process step, an inert gas and, without separate addition of oxygen, a silicon-organic or fluorocarbon compound are introduced into the process chamber for application of a slip layer,
wherein the slip layer is distinguished by a lower coefficient of friction than the scratch layer.

## Revendications

1. Procédé pour recouvrir des substrats en plastique d'un paquet de couches transparent, insensible aux rayures et aux frottements et résistant aux effets des intempéries avec un plasma brûlant en chambre sous vide, **caractérisé en ce que**
- dans une première étape du procédé, un gaz oxydant est admis dans la chambre du processus pour le nettoyage du substrat,
- dans une deuxième étape du procédé, un gaz inerte est admis dans la chambre du processus pour la réticulation,
- le cas échéant dans une troisième étape du procédé, un gaz oxydant et un composé de silicium organique sont admis dans la chambre du processus pour l'application d'une première couche d'arrêt,
- dans une quatrième étape du procédé, un gaz oxydant, un composé de silicium organique et un composé absorbant les UV sont admis dans la chambre du processus pour l'application d'une sous-couche avec absorbeur d'UV, le composé absorbant les UV pouvant être une substance aussi bien organique qu'anorganique et, dans le cas d'une substance organique, celui-ci étant vaporisé thermiquement dans le vide en l'absence prononcée du plasma et enfermé dans la couche grandissante et, dans le cas d'une substance anorganique, un ou plusieurs composés métalliques sous forme de vapeur étant admis sous l'effet d'un plasma d'oxygène, dont les métaux tels quels ou associés à du silicium forment des oxydes, oxynitrures ou nitrures absorbant les UV, la proportion de gaz oxydant par rapport au composé de silicium organique augmentant graduellement et/ou avec des interruptions d'environ zéro à un pendant la durée des quatre étapes du procédé et le plasma brûlant continuellement ou en mode pulsé,
- dans une cinquième étape du procédé, un gaz oxydant et un composé de silicium organique sont admis dans la chambre du processus pour l'application d'une couche anti-rayure, et
- dans une sixième étape du procédé, un gaz inerte et, sans adjonction séparée d'oxygène, un composé de silicium organique ou de fluorocarbone sont admis dans la chambre de processus pour l'application d'une couche antifriction, la couche antifriction **se caractérisant par** un coefficient de frottement plus bas que la couche anti-rayure.
